# DEMANDE DE BREVET EUROPEEN

(11) **EP 0 930 651 A1**
(43) Date de publication de la demande: **21.07.1999**
(21) Numéro de dépôt: 99400067.7
(22) Date de dépôt: 12.01.1999
(51) Int. Cl.: H01L 23/498, H01L 23/485, H01L 21/60, G06K 19/077

(54) **Procédé de connexion de plots d'un composant à circuits intégrés à des plages de connexion d'un substrat plastique au moyen de protubérances**

(30) Priorité: 13.01.1998 FR 9800274
(71) Demandeur: SCHLUMBERGER Systèmes, 92120 Montrouge (FR)
(72) Inventeur: Munch, Roger, 28170 Chateauneuf en Thymerais (FR)

(57) **Abrégé**

L'invention concerne un procédé de connexion de plots (2) d'un composant (1) à circuits intégrés à des plages de connexion (4) portées par un substrat (3) plastique au moyen de protubérances (10) électro-conductrices. L'invention se caractérise en ce que, le substrat (3) étant thermoplastique de température de transition vitreuse Tg(S), les protubérances (10) étant thermoplastiques de température de transition vitreuse Tg(P), on applique, auxdites protubérances (10), une énergie vibratoire ultrasonore de manière que la température desdites protubérances (10) atteigne la température Tg(P).

L'invention s'applique, en particulier, au domaine des cartes à puce.

## Description

L'invention concerne un procédé de connexion de plots d'un composant à circuits intégrés à des plages de connexion d'un substrat plastique au moyen de protubérances thermoplastiques électro-conductrices, par ultrasons.

Ce procédé s'applique avantageusement à la fabrication d'objets portables à mémoire destinés à identifier leur titulaire et permettre des transactions électroniques sécurisées, l'accès à des locaux réservés ou à des services tels que des services téléphoniques. Il s'agit notamment de cartes à puce dont le format est défini par les normes 7810 et 7816 ou de jetons à puce dont le format est habituellement du type de celui des modules d'identification abonnés (SIM).

Les cartes à puce comprennent essentiellement un corps de carte plastique et un composant semi-conducteur : la puce. Selon leur mode de fonctionnement, les cartes sont dites à contacts, sans contact ou mixtes, c'est-à-dire susceptibles de fonctionner avec et sans contacts.

Les cartes à puce à contacts comportent en général un module électronique montrant des plages de contacts affleurantes à la surface du corps de carte. La puce est connectée électriquement à des plages de connexion dudit module électronique elles-mêmes reliées à ces plages de contact.

Les cartes à puce ayant un mode de fonctionnement sans contact comprennent habituellement une antenne noyée dans le corps de carte. La puce est connectée aux bornes de connexion de cette antenne.

Ainsi que cela est expliqué dans le document brevet publié le 7 mai 1997 sous le numéro EP-0 772 232, pour la connexion électrique de plots de la puce aux plages de connexion du module électronique, on utilise avantageusement la technique dite de "flip-chip" ou "puce retournée" dans laquelle la puce, préalablement munie de protubérances (ou bumps), est reportée directement sur les plages de connexion reliées aux plages de contact du module, lesdites plages de connexion et de contact étant portées par un substrat plastique. Dans ce document brevet, il est suggéré que la connexion électrique des plots de la puce aux plages de connexion du substrat peut être réalisée par ultrasons. Néanmoins, dans le cas où le substrat est thermoplastique, sa température de transition vitreuse Tg(S) est toujours élevée, par exemple environ 150° C pour le polycarbonate (PC) utilisé dans ce brevet.

Par ailleurs, ainsi que cela est expliqué dans le document enregistré en France sous le numéro 96 15192 et non encore rendu publique au jour de dépôt de la présente demande de brevet en France, pour la connexion électrique de plots d'une puce aux bornes de connexion de l'antenne, la puce, préalablement munie de protubérances, est susceptible d'être reportée directement sur lesdites bornes selon la technique précitée de flip-chip. Dans ce cas, le substrat, portant les bornes de connexion de l'antenne, est bien souvent thermoplastique à bas point de fusion, les protubérances sont réalisées dans un matériau thermodurcissable ou sont métalliques et la soudure par ultrasons n'est pas envisagée.

En définitive, si la technique de report de puce à protubérances thermoplastiques par flip-chip et par ultrasons a été envisagée, elle l'a uniquement été dans le cas de la fabrication d'un module électronique où le substrat est plastique, le cas échéant thermoplastique, mais à température de transition vitreuse élevée. En effet, l'homme du métier a jugé qu'il n'était en pratique pas possible d'effectuer un soudage par ultrasons sur des substrats thermoplastiques dont la température de transition vitreuse était de l'ordre de celle ou inférieure à la température de transition vitreuse des protubérances thermoplastiques, un tel soudage ayant pour conséquence de déformer localement le substrat thermoplastique et d'altérer les plages de connexion particulièrement fragiles portées par lesdits substrats.

Considérant l'état de la technique qui précède, un problème technique que se propose de résoudre l'objet de l'invention est de permettre la connexion électrique de plots d'un composant à circuit intégrés à des plages de connexion portées par un substrat thermoplastique au moyen de protubérances thermoplastiques électro-conductrices.

Eu égard au problème ci-dessus, la solution de l'invention a pour objet un procédé de connexion de plots d'un composant à circuits intégrés à des plages de connexion portées par un substrat plastique au moyen de protubérances électro-conductrices, caractérisé en ce que, le substrat étant thermoplastique de température de transition vitreuse Tg(S), les protubérances étant thermoplastiques de température de transition vitreuse Tg(P), on applique, auxdites protubérances, une énergie vibratoire ultrasonore de manière que la température desdites protubérances atteigne la température Tg(P).

Les ultrasons portent le thermoplastique constitutif des protubérances à sa température de transition vitreuse Tg(P). Celui-ci fait alors l'objet d'un changement d'état et réalise le soudage des plots du composant à circuits intégrés aux plages de connexion portées par le substrat thermoplastique. Néanmoins, de manière surprenante, le thermoplastique constitutif du substrat ne subit pas de déformation, car la chaleur dégagée sur les protubérances diffuse le long des plages de connexion. Les plages de connexion et le substrat ne sont pas altérés.

Pour la première fois, on a donc, selon l'invention, soudé des puces par flip-chip sur des substrats thermoplastiques tels que du polychlorure de vinyle (PVC) ou du polyéthylène téréphtalate (PET) ou de l'acrylonitrile butadiène styrène (ABS) ou certains PC dont les températures de transition vitreuse sont basses.

On notera que, de manière avantageuse, la température de transition vitreuse Tg(S) du substrat thermoplastique est de l'ordre ou inférieure à la température de transition vitreuse Tg(P) des protubérances ; le substrat est en polychlorure de vinyle, en polyéthylène téréphtalate en acrylonitrile butadiène styrène ou en polycarbonate de faible température de transition vitreuse ; les plots du composant sont munis de protubérances alors que les plages de connexion du substrat ne comportent pas de telles protubérances ; le composant à circuits intégrés est une puce utilisée dans la fabrication d'objets portables à mémoire, notamment au format carte ; le substrat est une épaisseur d'un corps de carte et en ce que les plages de connexion sont des bornes de connexion d'une antenne ; le substrat est une feuille thermoplastique portant à l'une de ses faces, les plages de connexion, lesdites plages de connexion étant reliées à des plages de contact d'un micromodule ; et, pour la connexion, le composant est maintenu par des moyens de maintien par aspiration dudit composant.

L'invention sera mieux comprise à la lecture de la description non limitative qui va suivre, rédigée au regard des dessins annexés, dans lesquels :
- la figure 1 illustre un premier mode de mise en oeuvre du procédé selon l'invention relatif à la connexion d'une puce sur un substrat thermoplastique en vue de la fabrication d'un module électronique ;
- la figure 2 illustre un second mode de mise en oeuvre du procédé selon l'invention relatif à la connexion d'une puce sur un substrat thermoplastique en vue de la fabrication d'une carte sans contact ;
- la figure 3 schématise un dispositif permettant de générer les ultrasons pour la mise en oeuvre du procédé de l'invention ; et
- les figures 4A, 4B et 4C illustrent trois variantes de connexion selon le procédé de l'invention.

Selon l'invention, des plots de contact d'un composant à circuits intégrés sont connectés à des plages de contact d'un substrat thermoplastique au moyen de protubérances électro-conductrices thermoplastiques, par ultrasons.

Le composant à circuits intégrés selon l'invention est une puce du type de celles que l'on trouve habituellement dans les cartes à mémoire ou les jetons SIM. Une telle puce, référencée 1 sur l'ensemble des figures, s'inscrit généralement dans un parallélépipède rectangle dont les côtés ont une longueur de l'ordre d'un ou deux millimètres. Les circuits intégrés sont disposés sur une face active de la puce, recouverte d'une couche de passivation traversée par des vias formant des plots 2 de connexion qui permettent de relier électriquement les circuits intégrés de la puce.

On notera toutefois que, dans des applications autres que celles du domaine de la carte à puce mais entrant dans le cadre large de l'invention, le composant à circuits intégrés pourra se présenter sous une forme différente.

Le substrat 3 est formé d'une ou plusieurs épaisseurs isolantes, notamment une feuille thermoplastique par exemple d'ABS, de PET, de PVC, ou alors, d'un PC de faible température de transition vitreuse, dont les températures de transition vitreuse Tg(S) sont données ci-après :

| | |
|---|---|
| PVC | 65 à 80° C environ |
| PET | 75 à 80° C environ |
| ABS | 70 à 100° C environ |
| PC (feuille) | 130° C environ |

Ce substrat 3 porte des plages de connexion 4. Ces plages 4 sont notamment des encres conductrices polymériques chargées argent, parfois rechargées par un dépôt métallique, sérigraphiées à la surface du substrat 3, ou alors, des pistes métallisées principalement de cuivre reportées voire collées à la surface dudit substrat 3. L'épaisseur des plages de connexion est très faible, quelques microns voire quelques dizaines de microns.

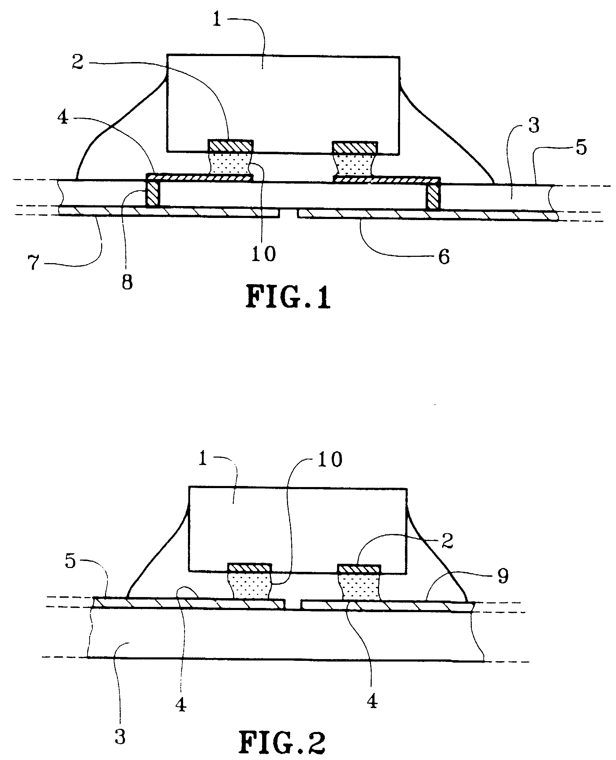

Dans un premier mode de mise en oeuvre du procédé selon l'invention représenté à la figure 1 et relatif à la connexion de la puce 1 sur un substrat 3 thermoplastique en vue de la fabrication d'un module électronique, ledit substrat 3 est constitué d'une feuille de PVC d'une épaisseur comprise entre 0,1 et 0,2 mm métallisée sur ses deux faces. Sur l'une 5 de ses faces, le substrat 3 comporte des plages de contact 6 et, sur sa face opposée 7, le substrat 3 comporte les plages de connexion 4. Les plages de contact 6 sont reliées électriquement aux plages de connexion 6 par des vias 8 ou des trous métallisés.

Dans un second mode de mise en oeuvre du procédé selon l'invention représenté à la figure 2 et relatif à la connexion d'une puce 1 sur un substrat 3 thermoplastique en vue de la fabrication d'une carte sans contact, ledit substrat 3 portant, sur l'une de ses faces, une antenne 9 sérigraphiée dont les extrémités ou bornes, forment des plages de connexion 4 pour le report de la puce 1.

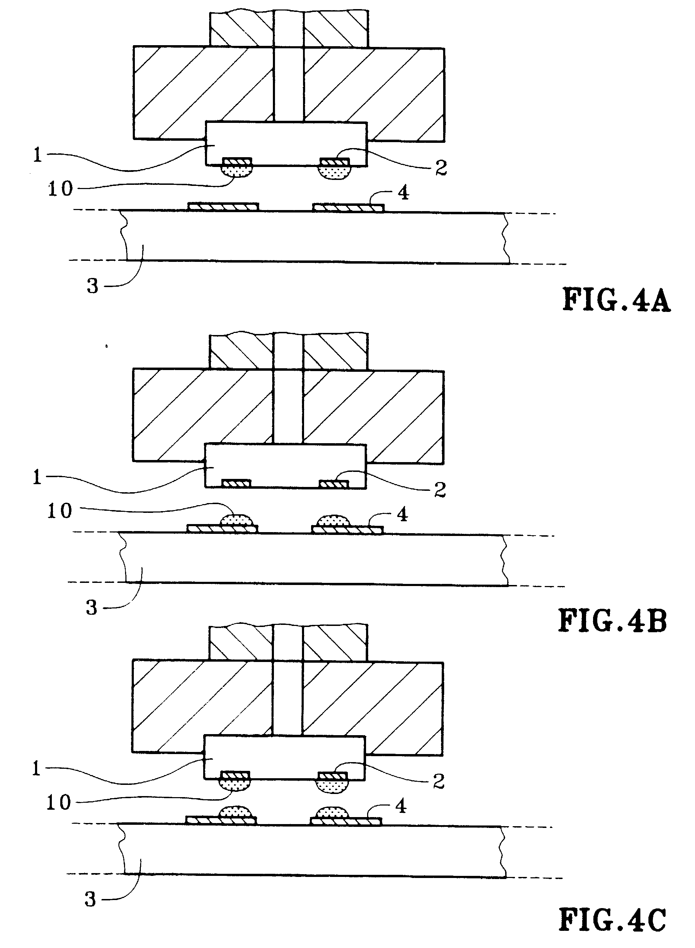

De même que dans l'état de la technique, les protubérances 10 (figures 4) sont, avant soudage, sensiblement hémisphériques. Il s'agit, dans l'invention, de protubérances thermoplastiques chargées de particules métalliques notamment chargées d'argent, dont la température de transition vitreuse est Tg(P).

Selon les différents modes de mise en oeuvre respectifs de l'invention représentés aux figures 4A, 4B et 4C, les plots 2 de la puce 1 sont munis de protubérances 10 alors que les plages de connexion 4 du substrat 3 ne comportent pas de telles protubérances 10, les plots 2 de la puce ne sont pas munis de protubérances 10 alors que les plages de connexion 4 du substrat 3 en sont munies, ou alors, les plots 2 de la puce 1 sont munis de protubérances 10 de même que les plages de connexion 4 du substrat 3.

Un dispositif permettant de générer les ultrasons pour la mise en oeuvre de l'invention est représenté à la figure 1. Il comporte un générateur 11 en courant électrique, un transducteur 12, une sonotrode 13 et des moyens 14 de maintien du composant 1 semi-conducteur. Le générateur 11 alimente le transducteur 12 en énergie électrique qui la transforme en énergie vibratoire et communique ladite énergie vibratoire aux moyens 14 de maintien du composant semi-conducteur, le long de la sonotrode 13. Cette énergie vibratoire est avantageusement modulée par un amplificateur/modulateur, non représenté sur les dessins, placé entre le transducteur 12 et la sonotrode 13. La puissance électrique libérée par le générateur est dans un exemple de l'ordre de 3 Watts et les moyens 14 de maintien sont formés d'un tube 15 muni d'une partie basse 16 élargie comportant une cavité 17 ouverte aux dimensions de la puce 1. Le tube 15 est relié à un système d'aspiration 18.

Ainsi, lorsque le système d'aspiration 18 est activé et qu'une puce 1 est reportée dans la cavité de la partie basse des moyens de maintien, un vide généré sur la face supérieure de ladite puce 1, maintient celle-ci en position et, lorsque le transducteur 12 est alimenté en énergie électrique par le générateur électrique 11, la puce 1 vibre. Cette puce 1 alors approchée du substrat 3 de manière que, dans le cas de la figure 4A, les extrémités inférieures des protubérances 10 viennent au contact des plages de connexion 4 portées par le substrat 3, que, dans le cas de la figure 4B, les extrémités supérieures des protubérances 10 viennent au contact des plots 2, ou alors, que, dans le cas de la figure 4C, les extrémités inférieures des protubérances 10 dont sont munies les plots 2 viennent au contact des protubérances 10 disposées à la surface des plages de connexion 4 du substrat 3. On notera que, dans le mode de mise en oeuvre de la figure 4A, il n'est pas nécessaire d'effectuer, avant la pose de la puce 1 sur un substrat 3, de repérage de protubérances 10 déposées à la surface des plages 4. On notera par ailleurs que dans les modes de mise en oeuvre des figures 4A et 4B, les protubérances 10 étant initialement fixées aux plots 2, l'intégrité de l'interface entre lesdites protubérances 10 et lesdits plots 2 ne peut être remise en cause au cours du procédé.

Une légère pression est appliquée sur la puce.

L'énergie vibratoire, alors concentrée aux points de contacts entre les protubérances 10 et, selon le cas, les plages de connexion 4 (figure 4A), les plots 2 (figure 4B) ou d'autres protubérances 10 (figure 4C), se transforme en énergie thermique suite aux frottements occasionnés aux extrémités des protubérances 10. La température des protubérances 10 croît rapidement et atteint rapidement la température de transition vitreuse Tg du thermoplastique constitutif desdites protubérances, en pratique quelques dixièmes de seconde. Celles-ci font alors l'objet d'un changement d'état. Elles passent d'un état solide à un état visqueux. La connexion électrique s'effectue alors entre les plots 2 de la puce 1 et les plages de connexion 4 du substrat 3.

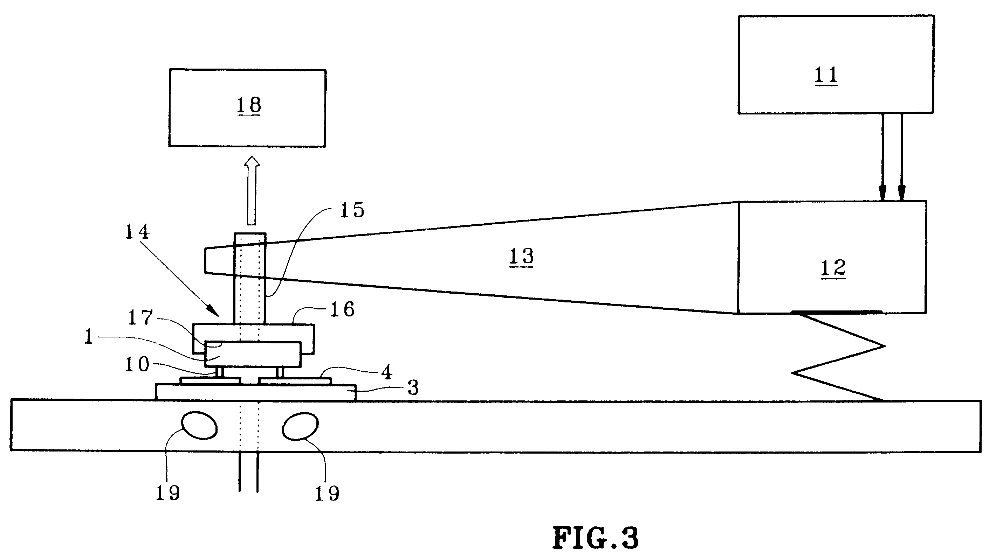

De manière avantageuse, le dispositif représenté à la figure 3 comporte des moyens 19 de chauffage destinés à porter le substrat à une température T supérieure à la température ambiante mais inférieure à Tg(S). Dans un exemple où S est en PVC, T = 60°C.

La quantité de chaleur libérée à l'interface de contact entre les protubérances et les plages 4, les plots 2 ou d'autres protubérances 10, n'est pas suffisante pour déformer le matériau thermoplastique du substrat 3, même si sa température de transition est de l'ordre ou inférieure à la température de transition vitreuse du matériau constitutif des protubérances 10. En effet, le temps de soudage par ultrasons est court et la quantité de chaleur libérée est transmise préférentiellement aux plages de connexion 4 et diffuse le long desdites plages 4 avant de diffuser dans le substrat 3.

Bien entendu, le procédé de l'invention est avantageusement applicable à un grand nombre de puces que l'on fixerait à un susbtrat de grande dimension pour une fabrication industrielle de cartes à puce.

Les gains en cadence pour la fabrication des cartes ou des modules sont considérables. Pour les modules par exemple, on passe de temps de soudage de l'ordre de 10 heures si Tg(S) est basse, à des temps de l'ordre du dixième de seconde.

## Revendications

1. Procédé de connexion de plots (2) d'un composant (1) à circuits intégrés à des plages de connexion (4) portées par un substrat (3) plastique au moyen de protubérances (10) électro-conductrices, caractérisé en ce que, le substrat (3) étant thermoplastique de température de transition vitreuse Tg(S), les protubérances (10) étant thermoplastiques de température de transition vitreuse Tg(P), on applique, auxdites protubérances (10), une énergie vibratoire ultrasonore de manière que la température desdites protubérances (10) atteigne la température Tg(P).

2. Procédé selon la revendication 1, caractérisé en ce que la température de transition vitreuse Tg(S) du substrat (3) thermoplastique est de l'ordre ou inférieure à la température de transition vitreuse Tg(P) des protubérances (10).

3. Procédé selon l'une des revendications 1 ou 2, caractérisé en ce que le substrat (3) est en polychlorure de vinyle, en polyéthylène téréphtalate en acrylonitrile butadiène styrène ou en polycarbonate de faible température de transition vitreuse.

4. Procédé selon l'une des revendications 1, 2 ou 3, caractérisé en ce que les plots (2) du composant (1) sont munis de protubérances (10) alors que les plages de connexion (4) du substrat (3) ne comportent pas de telles protubérances (10).

5. Procédé selon l'une des revendications précédentes, caractérisé en ce que le composant à circuits intégrés est une puce utilisée dans la fabrication d'objets portables à mémoire, notamment au format carte.

6. Procédé selon la revendication 5, caractérisé en ce que le substrat (3) est une épaisseur d'un corps de carte et en ce que les plages de connexion (4) sont des bornes de connexion d'une antenne.

7. Procédé selon la revendication 5, caractérisé en ce que le substrat (3) est une feuille thermoplastique portant à l'une de ses faces, les plages de connexion (4), lesdites plages de connexion étant reliées à des plages de contact (6) d'un micromodule.

8. Procédé selon l'une des revendications précédentes, caractérisé en ce que, pour la connexion, le composant (1) est maintenu par des moyens (14) de maintien par aspiration dudit composant (1).
